# EUROPEAN PATENT APPLICATION

(11) **EP 4 135 097 A2**
(43) Date of publication of application: **15.02.2023**
(21) Application number: 22188992.6
(22) Date of filing: 05.08.2022
(51) Int. Cl.: H01M 10/42, G01R 31/36, G05D 23/24, H01M 10/48, H01M 50/204, H01M 50/284, H01M 50/569, H01M 50/581

(54) **BATTERY PACK AND CONTROL METHOD FOR BATTERY PACK**

(30) Priority: 05.08.2021 KR 20210103440
(71) Applicant: Samsung SDI Co., Ltd., Yongin-si, Gyeonggi-do 17084 (KR)
(72) Inventor: LEE, Jihyeon, 17084 Yongin-si (KR); Ryu, Jaelim, 17084 Yongin-si (KR); MOON, Soodeok, 17084 Yongin-si (KR); PARK, Hwaduk, 17084 Yongin-si (KR)
(74) Representative: Marks & Clerk LLP

(57) **Abstract**

Provided are a battery pack and a control method for the battery pack. The battery pack includes battery cells and a measurement circuit unit configured to measure temperature information of the battery cells and including a first measurement circuit unit and a second measurement circuit unit, which respectively include a first type temperature measurement element and a second type temperature measurement element that have different characteristics of a resistance change according to a temperature change, wherein the first measurement circuit unit and the second measurement circuit unit are on a common base substrate or on different individual base substrates. Accordingly, erroneous detection of overheating may be prevented and overheating may be detected without omission by mixing the first type temperature measurement element and the second type temperature measurement element, which have different resistance characteristics according to the temperature change.

## Description

### BACKGROUND

### 1. Field

One or more embodiments relate to a battery pack and a control method for the battery pack.

### 2. Description of the Related Art

Generally, unlike primary batteries that are impossible to be charged, secondary batteries are batteries that are capable of being charged and discharged. The secondary batteries, which may be referred to as rechargeable batteries, are used as energy sources of mobile devices, electric vehicles, hybrid vehicles, electric bicycles, uninterruptible power supplies, and the like. Depending on a type of an external device to be applied, the secondary battery may be used in a form of a single battery or the plurality of secondary batteries may be connected to each other and bundled in one unit to be used in a form of a pack.

A small mobile device, such as a mobile phone, is operable for a certain period of time with an output and capacity of a single battery, but when long-term operation or high-power operation are required, like a larger mobile device, such as a laptop computer, or an electric vehicle and a hybrid vehicle, which consume a lot of power, a pack including a plurality of batteries is preferred due to output and capacity issues. Also, an output voltage or output current may be increased according to the number of embedded batteries.

### SUMMARY

One or more embodiments include a battery pack and a control method for the battery pack, wherein erroneous detection of overheating may be prevented and/or overheating may be detected without omission by mixing a first type temperature measurement element and a second type temperature measurement element, which have different resistance characteristics according to a temperature change.

Optional features will be set forth in part in the description which follows and, in part, will be apparent from the drawings, or may be learned by practice of the presented embodiments of the disclosure.

According to a first aspect of the invention, there is provided a battery pack comprising: battery cells; and a measurement circuit unit configured to measure temperature information of the battery cells and including a first measurement circuit unit and a second measurement circuit unit, which respectively include a first type temperature measurement element and a second type temperature measurement element that have different characteristics of a resistance change according to a temperature change, wherein the first measurement circuit unit and the second measurement circuit unit are on a common base substrate or on different individual base substrates.

In embodiments, the first and second measurement circuit units are a pair of circuit units suitable for together allowing a determination of whether one or more battery cell(s) are overheated. The determination may be based on a comparison of or difference between measurement value(s) derived from the first and second measurement circuit units respectively, e.g., a measurement value based on output(s) of the first measurement circuit unit and a measurement value based on output(s) of the second measurement circuit unit.

For example, the first type temperature measurement element may have a positive characteristic as a characteristic of the resistance change according to the temperature change, and the second type temperature measurement element may have a negative characteristic as a characteristic of the resistance change according to the temperature change.

For example, the battery cells may be arranged in a first direction, the first measurement circuit unit may include a pair of the first measurement circuit units arranged on both sides of the battery cells in a second direction crossing the first direction, and the second measurement circuit unit may include a pair of the second measurement circuit units arranged on both sides of the battery cells in the second direction.

According to various embodiments, the pair of first measurement circuit units may not be arranged on the both sides of the battery cells, but the first measurement circuit unit may include, for example, two or more first measurement circuit units, and similarly, the pair of second measurement circuit units may not be arranged on the both sides of the battery cells, but the second measurement circuit unit may include, for example, two or more second measurement circuit units.

The battery pack may further include a battery management system configured to determine whether the battery cells are overheated based on outputs of the pairs of first measurement circuit units and second measurement circuit units.

For example, the pair of first measurement circuit units may be connected in parallel to each other with respect to the battery management system, and the pair of second measurement circuit units may be connected in parallel to each other with respect to the battery management system.

For example, the pair of first measurement circuit units may be arranged at edge locations of the both sides of the battery cells in the second direction, a ground wire may be arranged at a center location of the battery cells between the pair of first measurement circuit units, and the pair of second measurement circuit units may be arranged respectively between the ground wire and different first measurement circuit units configuring the pair of first measurement circuit units.

For example, the pair of first measurement circuit units may have a symmetric structure based on the center location in the second direction.

For example, the first type temperature measurement element may be arranged between both ends of each first measurement circuit unit configuring the pair of first measurement circuit units to be balanced back and forth in the first direction (e.g. each first measurement circuit unit having an equal number of the elements either side of a substantially/exactly central point/line along the first direction between the ends of the circuit and/or unit, the elements preferably regularly spaced on each side), and one first measurement circuit unit from among the pair of first measurement circuit units may provide redundancy for another remaining first measurement circuit unit. (Any reference to 'back and forth' herein may generally mean 'backwards and forwards' or 'either side of', relative to a physical or virtual point along or line normal to a particular direction, e.g. relative to a line substantially centrally positioned along a length of a measurement circuit or measurement circuit unit. Throughout this disclosure, 'back' or 'backward' may merely mean in a direction opposite to 'forth' or forward' and thus may not indicate any specific actual direction in physical space).

For example, the first type temperature measurement element may be arranged to be biased towards a forward location in the first direction between both ends of one first measurement circuit unit configuring the pair of first measurement circuit units, and arranged to be biased toward a backward location in the first direction between both ends of another remaining first measurement circuit unit configuring the pair of first measurement circuit units. (A backward location in a direction is generally behind a more forward location along the same direction; backward and forward herein preferably being behind and ahead of a central position along the subject direction, e.g. behind or ahead of a central position or line between ends of a measurement circuit or measurement circuit unit).

For example, the first type temperature measurement element may include a plurality of first type temperature measurement elements connected to each other in series between both ends of the first measurement circuit unit, and the second type temperature measurement element may include a single second type temperature measurement element connected between both ends of the second measurement circuit unit.

For example, the battery cells may be arranged in the first direction, and the first type temperature measurement element may be arranged in one column in a first direction at an edge location of the battery cells in a second direction crossing the first direction.

For example, a plurality of the first type temperature measurement elements may be arranged to be allocated for each of the battery cells in a first direction in which the battery cells are arranged, and a plurality of the second type temperature measurement elements may be arranged in a number same as or less than the plurality of first type temperature measurement elements.

For example, the first type temperature measurement element or the second type temperature measurement element may be patterned or mounted in a form of a chip on the common base substrate or individual base substrates.

For example, the first type temperature measurement element or the second type temperature measurement element may be patterned with a print screen or patterned with a conductive line including a bent portion.

For example, each of the battery cells may include an electrode surface where an electrode is formed, a bottom surface opposite to the electrode surface, and a wide side surface occupying a relatively large area and a narrow side surface occupying a relatively small area, which connect the electrode surface and the bottom surface to each other.

For example, at least one of the first measurement circuit unit and the second measurement circuit unit may be arranged at least on a terminal surface of the battery cells.

For example, at least one of the first measurement circuit unit and the second measurement circuit unit may be arranged at least on the wide side surface of the battery cells.

For example, at least one of the first measurement circuit unit and the second measurement circuit unit may be arranged at least on the narrow side surface of the battery cells.

For example, at least one of the first measurement circuit unit and the second measurement circuit unit may be arranged at least on the bottom surface of the battery cells.

For example, the battery cells may include an angular battery cell including a case having a hexahedral shape, a circular battery cell including a case having a cylindrical shape, or a pouch battery cell including a case having a pouch shape, the case forming an exterior of the battery cells.

For example, the common base substrate or individual base substrates may include a flexible insulating film or a rigid insulating substrate.

According to one or more embodiments, a control method for a battery pack including battery cells and a measurement circuit unit configured to measure temperature information of the battery cells and including a first measurement circuit unit and a second measurement circuit unit, which respectively include a first type temperature measurement element and a second type temperature measurement element that have different characteristics of a resistance change according to a temperature change, the control method includes determining whether the battery cells are overheated by using a difference value between a first measurement value based on an output of the first measurement circuit unit and a second measurement value based on an output of the second measurement circuit unit.

For example, the first type temperature measurement element may have a positive characteristic as a characteristic of the resistance change according to the temperature change, and the second type temperature measurement element may have a negative characteristic as a characteristic of the resistance change according to the temperature change.

For example, the first type temperature measurement element may display a nonlinear rapid change above an inflection point of a profile of the resistance change according to the temperature change, and the second type temperature measurement element may display a linear gradual change in the profile of the resistance change according to the temperature change.

For example, the control method may further include determining whether the first measurement value is equal to or greater than a trigger point corresponding to an inflection point of the first type temperature measurement element, and when the first measurement value is equal to or greater than the trigger point while the second measurement value is equal to or greater than a threshold value, determining that the battery cells are overheated.

For example, the first measurement value and the second measurement value may change according to the temperature change while following resistance changes of the first type temperature measurement element and the second type temperature measurement element, respectively, and a size of a difference value between the first measurement value and the second measurement value may increase according to an increase in a temperature.

For example, the determining of whether the battery cells are overheated may include determining that the battery cells are overheated when the difference value between the first measurement value and the second measurement value is equal to or greater than a threshold value, as a result of comparing the difference value with the threshold value.

For example, the threshold value may be a value pre-set to a difference value between first temperature data based on resistance of the first type temperature measurement element and second temperature data based on resistance of the second type temperature measurement element.

For example, the difference value between the first measurement value and the second measurement value may be calculated by using a first conversion measurement value and a second conversion measurement value, which are preferably obtained by, in effect, converting a number of first type temperature measurement elements included in the first measurement circuit unit and a number of second type temperature measurement elements included in the second measurement circuit unit to be equal. For example, one of the values may be multiplied by a ratio of numbers of temperature measurement elements P of the first and second measurement circuits.

For example, the first measurement circuit unit may include a plurality of the first type temperature measurement elements arranged to be allocated for each of the battery cells according to a first direction in which the battery cells are arranged, and the second measurement circuit unit may include different second measurement circuit units including single second type temperature measurement elements, respectively.

For example, the plurality of first type temperature measurement elements may be connected to each other in series between both ends of the first measurement circuit unit, and the single second type temperature measurement elements may be connected between both ends of the different second measurement circuit units.

For example, the first conversion measurement value and the second conversion measurement value may be obtained by converting the first measurement value based on the output of the first measurement circuit unit into the first conversion measurement value, and converting, into the second conversion measurement value, a value obtained by multiplying a number of battery cells by a representative value from among different second measurement values based on outputs of the different second measurement circuit units.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is an exploded perspective view of a battery pack, according to an embodiment;
FIG. 2 is a perspective view of a battery cell of FIG. 1;
FIG. 3 is a view illustrating an arrangement of a measurement circuit unit of FIG. 1;
FIGS. 4 and 5 are diagrams illustrating behaviors of a positive temperature coefficient (PTC), in which a resistance change according to a temperature change has a positive characteristic, and a negative temperature coefficient (NTC), in which a resistance change according to a temperature change has a negative characteristic, according to embodiments of a first type temperature measurement element and a second type temperature measurement element;
FIG. 6 is a view illustrating a configuration of a measurement circuit unit, according to an embodiment;
FIG. 7 is a view illustrating a configuration of a measurement circuit unit, according to another embodiment;
FIGS. 8A through 8D are views illustrating a configuration of a measurement circuit unit, according to different embodiments;
FIG. 9 is a view for describing a battery pack according to a modified embodiment of FIG. 3;
FIG. 10 is a view for describing a battery pack according to a modified embodiment of FIG. 1;
FIG. 11 is a view illustrating a connection state of a first measurement circuit unit and a second measurement circuit unit;
FIG. 12 is a flowchart of a control method for a battery pack, according to an embodiment; and
FIG. 13 is a view illustrating a schematic configuration of a battery management system, according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, a battery pack and a control method for the battery pack, according to embodiments, will be described with reference to accompanying drawings.

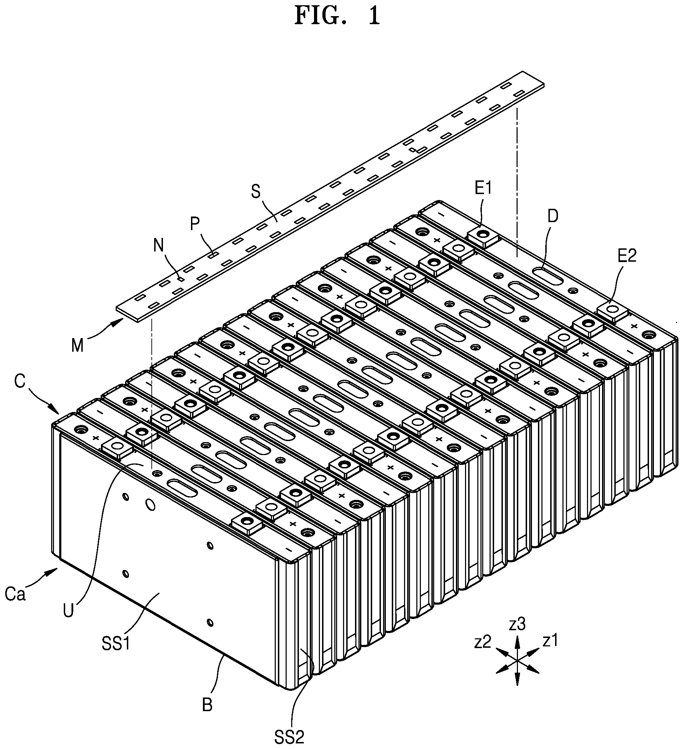

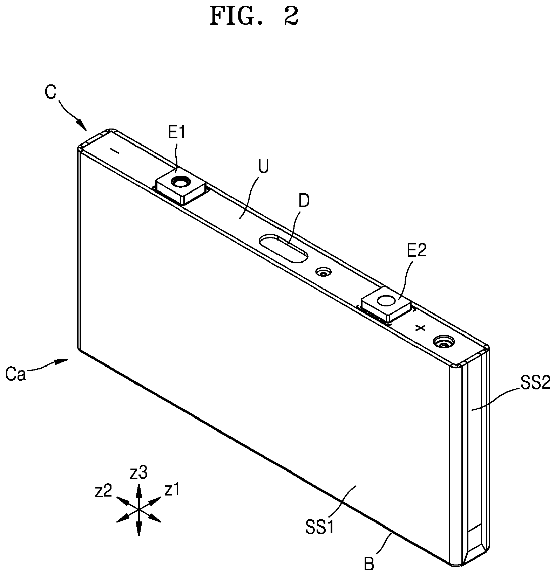

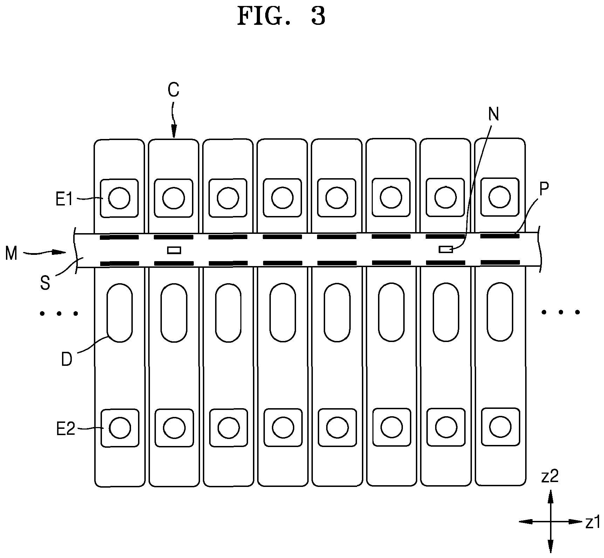

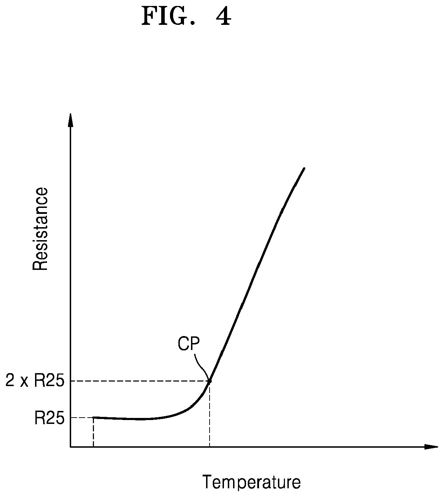

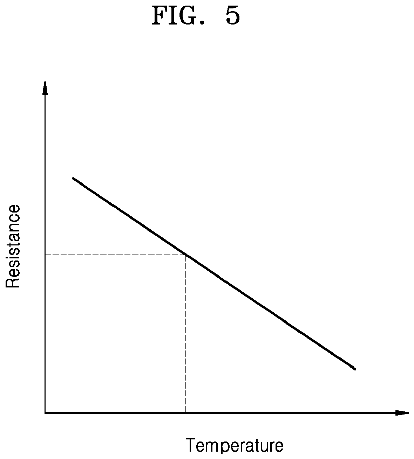

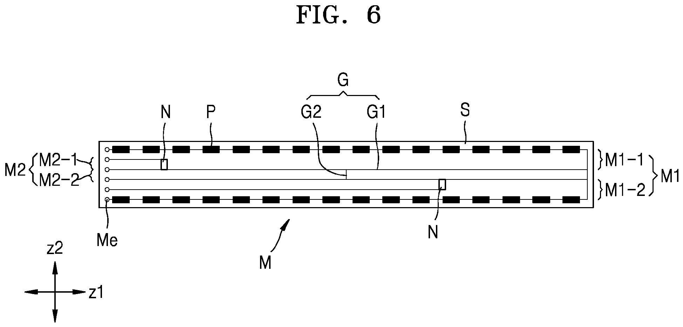

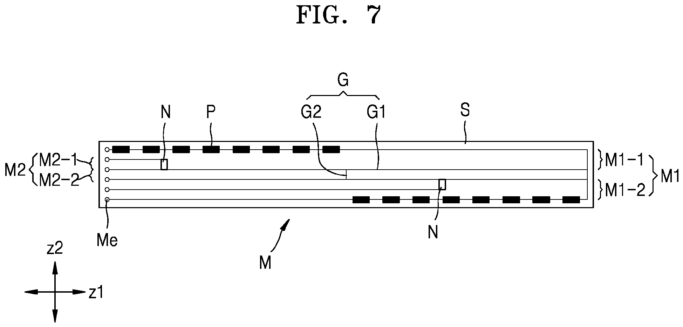

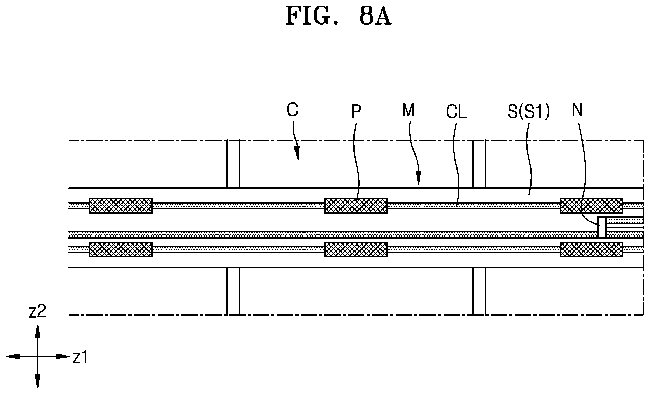

FIG. 1 is an exploded perspective view of a battery pack, according to an embodiment. FIG. 2 is a perspective view of a battery cell C of FIG. 1. FIG. 3 is a view illustrating an arrangement of a measurement circuit unit M of FIG. 1. FIGS. 4 and 5 are diagrams illustrating behaviors of a positive temperature coefficient (PTC), in which a resistance change according to a temperature change has a positive characteristic, and a negative temperature coefficient (NTC), in which a resistance change according to a temperature change has a negative characteristic, according to embodiments of a first type temperature measurement element P and a second type temperature measurement element N. FIG. 6 is a view illustrating a configuration of the measurement circuit unit M, according to an embodiment. FIG. 7 is a view illustrating a configuration of the measurement circuit unit M, according to another embodiment. FIGS. 8A through 8D are views illustrating a configuration of the measurement circuit unit M, according to different embodiments.

Referring to the drawings, the battery pack according to an embodiment may include the battery cell C and the measurement circuit unit M configured to measure temperature information of the battery cell C and including a first measurement circuit unit M1 and second measurement circuit unit M2, which respectively include the first type temperature measurement element P and second type temperature measurement element N that have different characteristics of a resistance change according to a temperature change, wherein the first measurement circuit unit M1 and second measurement circuit unit M2 are formed on a common base substrate S. It is noted that measurement circuit units such as the first and second measurement circuit units M1, M2 may alternatively be referred to as measurement circuits.

The battery pack according to an embodiment may include a plurality of the battery cells C arranged in a first direction Z1. The battery cell C may be provided in any one of various shapes, such as an angular shape and a circular shape, and according to an embodiment, the battery cell C may be provided as an angular battery cell including a case Ca having approximately a hexahedral shape. According to various embodiments, the battery cell C may be provided as a circular battery cell including the case Ca having approximately a cylindrical shape.

The battery cell C may include an electrode assembly (not shown), the case Ca accommodating the electrode assembly, and first electrode E1 and second electrode E2 provided on the case Ca and electrically connected to the electrode assembly. For example, the first electrode E1 and second electrode E2 may be different electrodes spaced apart from each other in a second direction Z2 crossing the first direction Z1. According to an embodiment, the battery cell C may be provided as, depending on a type of the case Ca, an angular battery cell that includes a relatively rigid frame and has a hexahedral shape, or a pouch battery cell that includes the case Ca having a relatively flexible pouch shape. Technical features described below are substantially identically applied to both the angular battery cell and the pouch battery cell.

According to an embodiment, the battery cell C or the case Ca forming an exterior of the battery cell C may include an electrode surface U where the first electrode E1 and second electrode E2 are formed, a bottom surface B opposite to the electrode surface U, a wide side surface SS1 occupying a relatively large area and where the plurality of battery cells C arranged in the first direction Z1 face each other, and a narrow side surface SS2 occupying a relatively small area, wherein the wide side surface SS1 and narrow side surface SS2 connect the electrode surface U and the bottom surface B to each other. For example, the electrode surface U and bottom surface B may face each other in a third direction Z3 crossing the first direction Z1 and second direction Z2.

The battery pack according to an embodiment may include the measurement circuit unit M configured to measure the temperature information of the battery cell C. The measurement circuit unit M may extend in the first direction Z1 in which the battery cells C are arranged, and may extend along the electrode surface U or narrow side surface SS2 of the battery cell C or extend generally in the first direction Z1 while a branch is provided between the wide side surfaces SS1 of the neighboring battery cells C).

According to an embodiment, the measurement circuit unit M may extend in the first direction Z1 in which the battery cells C are arranged, and may be arranged between the different first electrode E1 and second electrode E2 arranged at edge locations of both sides in the second direction Z2. For example, the measurement circuit unit M may be arranged, in the second direction Z2, between one of the first electrode E1 and second electrode E2 and a vent hole D formed at a center location between the first electrode E1 and second electrode E2. The measurement circuit unit M is arranged between one of the first electrode E1 and second electrode E2 and the vent hole D, thereby not interfering with release of a high-temperature high-pressure gas discharged through the vent hole D and avoiding damage caused by the release of the high-temperature high-pressure gas.

The battery pack according to an embodiment is for measuring the temperature information of the battery cell C, and may include the first measurement circuit unit M1 and second measurement circuit unit M2 respectively including the first type temperature measurement element P and second type temperature measurement element N that have different characteristics of the resistance change according to the temperature change.

For example, the first type temperature measurement element P may include a PTC device that displays a positive characteristic for a change in electric resistance according to the temperature change, and the second type temperature measurement element N may include an NTC device that displays a negative characteristic for a change in electric resistance according to the temperature change. In detail, FIGS. 4 and 5 illustrate a profile showing the positive characteristic of the first type temperature measurement element P and a profile showing the negative characteristic of the second type temperature measurement element N, respectively. For example, the first type temperature measurement element P may have a nonlinear behavior in which there is almost no change in a relatively low temperature section according to a temperature change from a room temperature (room temperature resistance: R25), but a rapid change is displayed from a relatively high temperature section around an inflection point CP (twice the room temperature resistance: 2 x R25). In detail, resistance may barely change according to the temperature change in the relatively low temperature section, but may rapidly change from a high temperature section equal to or greater than a temperature (the inflection point CP) corresponding to resistance (2 x R25) twice the room temperature resistance (R25). For example, an abnormal temperature may be sensed by detecting a threshold point (for example, the inflection point CP) where a rapid resistance change of the first type temperature measurement element P is started according to an increase in a temperature, and the abnormal temperature or a sign of the abnormal temperature may be sensed by detecting the pre-set threshold point.

According to an embodiment, together with the first type temperature measurement element P, the second type temperature measurement element N having a different resistance characteristic from the first type temperature measurement element P is introduced, and overheating is determined considering outputs of the first type temperature measurement element P and second type temperature measurement element N together. Accordingly, compared with a comparative example of determining overheating only with the output of the first type temperature measurement element P, an abnormal temperature or overheating of the battery cell C may be precisely detected without omission. As described above, due to a rapid resistance change in a high temperature section and a nonlinear behavior, it may not be easy for the first type temperature measurement element P to accurately measure a temperature of the battery cell C.

Unlike the nonlinear behavior of the first type temperature measurement element P, the second type temperature measurement element N may display an approximately linear change from a room temperature. The second type temperature measurement element N may display an approximately linear change throughout a low temperature section and the high temperature section instead of a nonlinear behavior different in the low temperature section and the high temperature section like the first type temperature measurement element P. Accordingly, the temperature of the battery cell C may be further accurately measured through the second type temperature measurement element N rather than the first type temperature measurement element P. According to an embodiment of the disclosure, erroneous detection of overheating may be prevented and overheating may be detected without omission by introducing together the first type temperature measurement element P and second type temperature measurement element N having different characteristics of a resistance change according to a temperature change.

The battery pack according to an embodiment may include the plurality of battery cells C arranged in one column in the first direction Z1, and may include the measurement circuit unit M for measuring state information from the plurality of battery cells C arranged in one column. Here, the measurement circuit unit M may include a first measurement circuit unit M1 including at least two first type temperature measurement elements P arranged at different measurement locations, and a second measurement circuit unit M2 including at least two second type temperature measurement elements N arranged at different measurement locations. The first measurement circuit unit M1 may include at least two first measurement circuit units M1 each including the plurality of first type temperature measurement elements P.

According to an embodiment, the first measurement circuit unit M1 may include the plurality of first type temperature measurement elements P arranged to be allocated respectively for the battery cells C, in the first direction Z1 in which the battery cells C are arranged. Here, each first type temperature measurement element P may display a change in resistance while reacting to a temperature of each allocated battery cell C. According to an embodiment, the plurality of first type temperature measurement elements P may be arranged in one column in the first direction Z1 at edge locations of the first measurement circuit unit M1 in the first direction Z1, and may be arranged at measurement locations corresponding to the battery cells C respectively.

According to an embodiment, the first measurement circuit unit M1 may include two or more first measurement circuit units M1 (the two or more units may be referred to as sub-units or -circuits of the first measurement circuit M1 ), and for example, may include a (1-1)th measurement circuit unit M1-1 and a (1-2)th measurement circuit unit M1-2. According to an embodiment, a pair of the first measurement circuit units M1 may be arranged at different measurement locations on left and right in the second direction Z2 to detect the temperature of the battery cell C at different measurement locations. Also, the first measurement circuit units M1 substantially having a same configuration may be arranged at symmetric locations in the second direction Z2, and thus even when one first measurement circuit unit M1 is disconnected, redundancy may be provided through another first measurement circuit unit M1 such that temperature detection is not stopped. However, according to various embodiments, there may be a single first measurement circuit unit M1 rather than the pair of first measurement circuit units M1 being arranged at different measurement location on left and right in the second direction Z2. For example, the temperature of the battery cell C may be detected through a single first measurement circuit unit M1 arranged at a measurement location on left or right in the second direction Z2 or at a center measurement location in the second direction Z2.

In each first measurement circuit unit M1, the first type temperature measurement elements P may be connected to each other in series between both ends of the first measurement circuit unit M1. In other words, the first type temperature measurement elements P may be connected to each other in series between both ends of the first measurement circuit unit M1, in the first direction Z1 in which the battery cells C are arranged, and an abnormal temperature or overheating of the battery cell C may be detected through combined resistance obtained by adding resistances of the first type temperature measurement elements P connected to each other in series. As described above, the pair of first measurement circuit units M1 arranged to provide redundancy at different measurement location in the second direction Z2 may have a substantially same structure, may each detect the combined resistance obtained by adding the resistances of the plurality of first type temperature measurement elements P connected to each other in series between both ends of the first measurement circuit unit M1, and may detect individual combined resistance for each first measurement circuit unit M1.

According to an embodiment, the abnormal temperature or overheating of the battery cell C may be detected considering all combined resistances of the different first measurement circuit units M1, for example, a maximum value or average value of different combined resistances of the different first measurement circuit units M1, or selectively considering only one of the combined resistances of the first measurement circuit units M1. The combined resistances output from the different first measurement circuit units M1 may be used as inputs to determine whether a disconnection condition of the first measurement circuit unit M1 is satisfied, and the abnormal temperature or overheating of the battery cell C may be detected by excluding combined resistance of a disconnected first measurement circuit unit M1 and using combined resistance of a remaining first measurement circuit unit M1.

Unlike the first measurement circuit unit M1, the second measurement circuit unit M2 may include at least two second measurement circuit units M2 each including a single second type temperature measurement element N, and according to an embodiment, the second measurement circuit unit M2 may include two second measurement circuit units M2, for example, a (2-1)th measurement circuit unit M2-1 and a (2-2)th measurement circuit unit M2-2. According to an embodiment, the different second measurement circuit units M2 (the (2-1)th measurement circuit unit M2-1 and the (2-2)th measurement circuit unit M2-2) may include different second type temperature measurement elements N for detecting the temperature of the battery cell C at different measurement locations by being arranged at different measurement locations in the first direction Z1 in which the battery cells C are arranged.

In other words, according to an embodiment, the second type temperature measurement elements N may each form the second measurement circuit unit M2, and the different second type temperature measurement elements N may be connected to both ends of the different second measurement circuit units M2 to be connected to a battery management system BMS described below, through different measurement channels. According to an embodiment, an output of the second type temperature measurement element N may be connected to the different first electrode and second electrode of the battery management system BMS through the different second measurement circuit units M2 (for example, wires of the second measurement circuit units M2) providing the different measurement channels. According to an embodiment, the second type temperature measurement element N may be provided in a form of a chip, and the output of the second type temperature measurement element N may be input to the battery management system BMS through a dedicated measurement channel or the second measurement circuit unit M2 (for example, the wire of the second measurement circuit unit M2).

According to an embodiment, a pair of the second measurement circuit units M2 may be arranged at measurement locations between the pair of first measurement circuit units M1 arranged at edge locations on both sides of the measurement circuit unit M in the second direction Z2. The second type temperature measurement elements N respectively included in the pair of second measurement circuit units M2 may be arranged at different measurement locations in the first direction Z1 and at the same time, may be arranged at different measurement locations in the second direction Z2 so as to avoid physical interference between the second measurement circuit units M2 arranged adjacent to each other in the second direction Z2. In other words, the second type temperature measurement elements N respectively included in the pair of second measurement circuit units M2 may be arranged at measurement locations spaced apart from each other in the first direction Z1 and second direction Z2, and for example, may be arranged along diagonal locations following the first direction Z1 and second direction Z2 together.

The different first measurement circuit units M1 (the (1-1)th measurement circuit unit M1-1 and (1-2)th measurement circuit unit M1-2) and the different second measurement circuit units M2 (the (2-1)th measurement circuit unit M2-1 and (2-2)th measurement circuit unit M2-2) may share a ground wire G. The ground wire G may be arranged at a center location between the different second measurement circuit units M2 in the second direction Z2, and may include two or more conductive wires G1 and a connecting wire G2 between the different conductive wires G1, considering wire resistance. The ground wire G may provide one ends of the different first measurement circuit units M1 (the (1-1)th measurement circuit unit M1-1 and (1-2)th measurement circuit unit M1-2) and second measurement circuit units M2 (the (2-1)th measurement circuit unit M2-1 and (2-2)th measurement circuit unit M2-2).

According to an embodiment, the different first measurement circuit units M1 (the (1-1)th measurement circuit unit M1-1 and (1-2)th measurement circuit unit M1-2) may be arranged at the edge locations of the measurement circuit unit M in the second direction Z2, the ground wire G may be arranged at the center location between the different first measurement circuit units M1 (the (1-1)th measurement circuit unit M1-1 and (1-2)th measurement circuit unit M1-2), and the different second measurement circuit units M2 (the (2-1)th measurement circuit unit M2-1 and (2-2)th measurement circuit unit M2-2) may be respectively arranged between the ground wire G and the first measurement circuit units M1 (the (1-1)th measurement circuit unit M1-1 and (1-2)th measurement circuit unit M1-2).

In an embodiment shown in FIG. 6, the different first measurement circuit units M1, i.e., the (1-1)th measurement circuit unit M1-1 and (1-2)th measurement circuit unit M1-2, may include the plurality of first type temperature measurement elements P arranged symmetrically, and may detect the abnormal temperature or overheating of the battery cell C in balance back and forth in the first direction Z1 (preferably based on comparison of back and forth measurements) through the first type temperature measurement elements P, which are preferably arranged in balance back and forth in the first direction Z1 in which the battery cells C are arranged (e.g. each first measurement circuit unit having an equal number of the elements either side of a substantially/exactly central point/line along the first direction between the ends of the circuit and/or unit, the elements preferably regularly spaced on each side). For example, in the embodiment of FIG. 6, the (1-1)th measurement circuit unit M1-1 and (1-2)th measurement circuit unit M1-2 may expect a substantially equal output when ignoring a temperature deviation and measurement error in the second direction Z2.

The first type temperature measurement elements P may be arranged in the first direction Z1 at the edge locations in the second direction Z2 in which the different first measurement circuit units M1 face each other, and may sensitively react to temperatures inside the battery cells C through the first electrode E1 and second electrode E2 of the battery cells C at the edge locations in the second direction Z2. Also, the first type temperature measurement elements P may be symmetrically arranged at the edge locations on farthest both sides in the second direction Z2 so as to avoid physical interference or thermal interference between the different first type temperature measurement elements P belonging to the different first measurement circuit units M1. Accordingly, the plurality of first type temperature measurement elements P may be connected to each other along wires at the edge locations in the second direction Z2 at each first measurement circuit unit M1, and the first type temperature measurement elements P may not be connected to a wire at an inner location in the second direction Z2.

FIG. 7 is a view schematically illustrating the measurement circuit unit M, according to another embodiment. The measurement circuit unit M of FIG. 7 may include the different first measurement circuit units M1 (the (1-1)th measurement circuit unit M1-1 and (1-2)th measurement circuit unit M1-2), and each of the first measurement circuit units M1 (the (1-1)th measurement circuit unit M1-1 and (1-2)th measurement circuit unit M1-2) may include the plurality of first type temperature measurement elements P connected to each other in series between both ends.

In the embodiment shown in FIG. 7, the different first measurement circuit units M1, i.e., the (1-1)th measurement circuit unit M1-1 and (1-2)th measurement circuit unit M1-2, may include the plurality of first type temperature measurement elements P arranged asymmetrically. The (1-1)th measurement circuit unit M1-1 may include the plurality of first type temperature measurement elements P biased forward in the first direction Z1 in which the battery cells C are arranged, whereas the (1-2)th measurement circuit unit M1-2 may include the plurality of first type temperature measurement elements P biased backward in the first direction Z1. As such, the plurality of first type temperature measurement elements P are arranged to have different measurement locations in the first direction Z1 in which the battery cells C are arranged, for example, the (1-1)th measurement circuit unit M1-1 includes the plurality of first type temperature measurement elements P arranged at front measurement locations in the first direction Z1 while the (1-2)th measurement circuit unit M1-2 includes the plurality of first type temperature measurement elements P arranged at rear measurement locations in the first direction Z1. Accordingly, the abnormal temperature or overheating of the battery cells C arranged forward in the first direction Z1 may be sensitively detected through an output of the (1-1)th measurement circuit unit M1-1, and the abnormal temperature or overheating of the battery cells C arranged backward in the first direction Z1 may be sensitively detected through an output of the (1-2)th measurement circuit unit M1-2. For example, the abnormal temperature or overheating of the battery cells C arranged in the first direction Z1 may be sensed in (preferably based on, eg by comparison of measurements) balance back and forth, by combining (eg comparing) the outputs of the (1-1)th measurement circuit unit M1-1 and (1-2)th measurement circuit unit M1-2.

For example, according to an embodiment, the number of first type temperature measurement elements P included in the (1-1)th measurement circuit unit M1-1 may be designed to be the same as the number of first type temperature measurement elements P included in the (1-2)th measurement circuit unit M1-2. The number of first type temperature measurement elements P included in the entire first measurement circuit units M1 in the first direction Z1 in which the battery cells C are arranged may be halved, and the (1-1)th measurement circuit unit M1-1 may be formed by connecting the half of the first type temperature measurement elements P arranged at the front measurement locations in the first direction Z1 and the (1-2)th measurement circuit unit M1-2 may be formed by connecting the remaining half of the first type temperature measurement elements P arranged at the rear measurement locations, thereby equally bisecting a measurement load of the (1-1)th measurement circuit unit M1-1 and a measurement load of the (1-2)th measurement circuit unit M1-2.

According to an embodiment, considering that the number of front measurement locations (or the number of front battery cells C) and the number of rear measurement locations (or the number of rear battery cells C), which are in charge of the (1-1)th measurement circuit unit M1-1 and (1-2)th measurement circuit unit M1-2, are the same, a deviation between the combined resistance of the (1-1)th measurement circuit unit M1-1 and the combined resistance of the (1-2)th measurement circuit unit M1-2) caused by wire resistance may be easily removed or reduced when wire resistance of the (1-1)th measurement circuit unit M1-1 and wire resistance of the (1-2)th measurement circuit unit M1-2 are designed to be balanced. In this regard, according to an embodiment, an entire wire length of the (1-1)th measurement circuit unit M1-1 and an entire wire length of the (1-2)th measurement circuit unit M1-2 may be designed to be the same. For example, when a terminal Me formed at one end portion of the first measurement circuit unit M1 is connected to an electrode of the battery management system BMS at a forward location of the first measurement circuit unit M1 in the first direction Z1, the (1-1)th measurement circuit unit M1-1 in charge of the relatively front measurement location does not extend across only the front measurement locations (the front first type temperature measurement elements P) in the first direction Z1, but may include an extending portion extending in the first direction Z1 at backwards to be balanced with the (1-2)th measurement circuit unit M1-2 in the entire wire length.

According to various embodiment, the number of first type temperature measurement elements P included in the (1-1)th measurement circuit unit M1-1 may be designed to be different from the number of first type temperature measurement elements P included in the (1-2)th measurement circuit unit M1-2. The number of first type temperature measurement elements P included in the entire first measurement circuit units M1 in the first direction Z1 in which the battery cells C are arranged may be divided in a set ratio, and the (1-1)th measurement circuit unit M1-1 may be formed by connecting some of the first type temperature measurement elements P arranged at the front measurement locations in the first direction Z1 and the (1-2)th measurement circuit unit M1-2 may be formed by connecting the remaining some of the first type temperature measurement elements P arranged at the rear measurement locations.

For example, according to various embodiments, considering characteristics of the first type temperature measurement elements P, such as dispersion or resolution of the first type temperature measurement elements P, the number of first type temperature measurement elements P may be divided in an odd number, such as trisection, instead of bisection, so as to configure different first measurement circuit units M1.

In the embodiment shown in FIG. 7, the number of first type temperature measurement elements P included in the measurement circuit unit M is reduced in overall by using the different first measurement circuit units M1 having an asymmetric arrangement of the first type temperature measurement elements P, thereby reducing manufacturing costs of the measurement circuit unit M. Also, by halving the plurality of first type temperature measurement elements P arranged in the first direction Z1, the different (1-1)th measurement circuit unit M1-1 and (1-2)th measurement circuit unit M1-2) are configured as the (1-1)th measurement circuit unit M1-1 is formed by using the half of the first type temperature measurement elements P and the (1-2)th measurement circuit unit M1-2 is formed by using the remaining half of the first type temperature measurement elements P. Accordingly, even when one first measurement circuit unit M1 is disconnected, an abnormal temperature or overheating may be detected without stopping of temperature measurement, by using the remaining first measurement circuit unit M1.

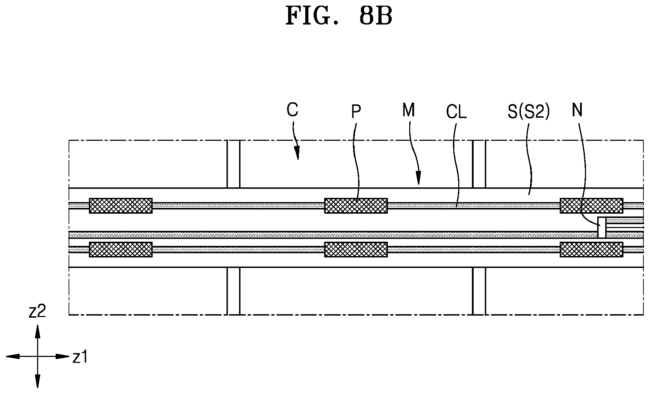

Referring to FIGS. 8A and 8B together, the measurement circuit unit M may be packaged, as the common base substrate S forming a support base of the measurement circuit unit M, to a flexible circuit board including a flexible insulating film S1 or a rigid circuit board including a rigid insulating substrate S2, and the first measurement circuit unit M1 and second measurement circuit unit M2 may be modularized as one component that is not separated from each other. In detail, the first measurement circuit unit M1 and second measurement circuit unit M2 may be supported on the common base substrate S, and for example, the first measurement circuit unit M1 and second measurement circuit unit M2 may be supported on the flexible insulating film S1 that is the common base substrate S and thus may be packaged to one flexible circuit board, or the first measurement circuit unit M1 and second measurement circuit unit M2 may be supported on the rigid insulating substrate S2 that is the common base substrate S and thus may be packaged to one rigid circuit board. For reference, in the present specification, an edge location or center location of the measurement circuit unit M in the second direction Z2 crossing the first direction Z1 in which the battery cells C are arranged may correspond to an edge location or center location of the common base substrate S forming a base of the measurement circuit unit M.

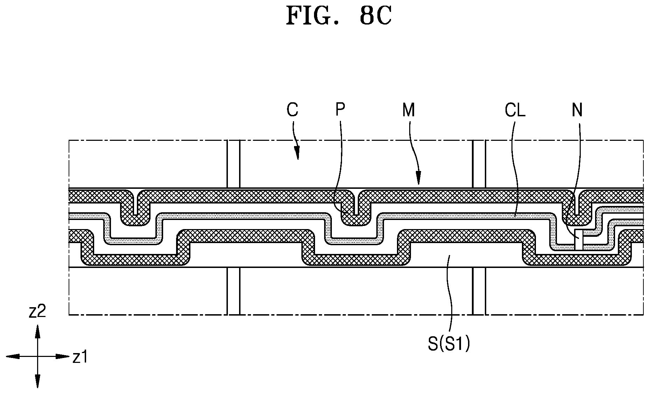

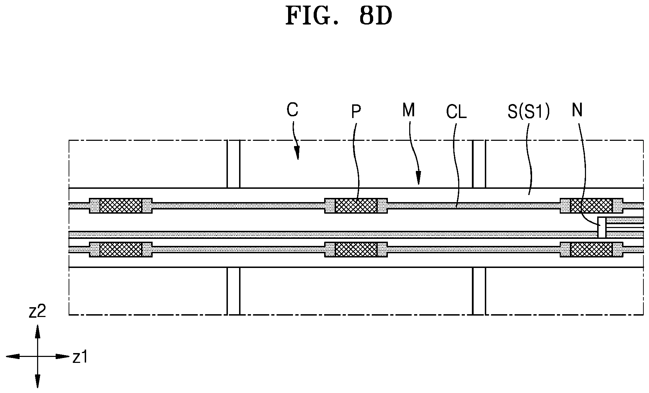

Referring to FIGS. 8A through 8D, according to an embodiment of the disclosure, the first type temperature measurement element P and second type temperature measurement element N may be realized in various forms. For example, the first type temperature measurement element P may be patterned on the common base substrate S by using a print screen (FIGS. 8A and 8B), or may be mounted on the common base substrate S in a form of a chip (FIG. 8D). Also, the second type temperature measurement element N may be mounted on the common base substrate S in a form of a chip (FIGS. 8A through 8D). Here, a conductive line CL may be patterned on the common base substrate S, and to be connected to the conductive line CL, the first type temperature measurement element P patterned by using the print screen may be arranged (FIGS. 8A and 8B) or the second type temperature measurement element N in a form of a chip may be mounted (FIGS. 8A through 8D). Referring to FIGS. 8A and 8B, according to some embodiments, the first measurement circuit unit M1 and second measurement circuit unit M2 may be supported on the common base substrate S by using the flexible insulating film S1 as the common base substrate S (FIG. 8A) or may be supported on the common base substrate S by using the rigid insulating substrate S2 as the common base substrate S (FIG. 8B). Also, the first type temperature measurement element P may be patterned on the common base substrate S by using the print screen (FIGS. 8A and 8B) or mounted in a form of a chip (FIG. 8D), and the second type temperature measurement element N may be mounted on the common base substrate S in a form of a chip. Referring to FIG. 8C, the first type temperature measurement element P may be patterned by the conductive line CL on the common base substrate S, and for example, a bent portion may be formed in a partial section of the conductive line CL to increase resistance, such that a change in resistance according to a temperature change may be easily measured.

According to an embodiment, the second type temperature measurement element N may be provided in a form of a chip and need to configure a dedicated second measurement circuit unit M2 for providing a separate measurement channel. Accordingly, the number of second type temperature measurement elements N may be less than that of the first type temperature measurement elements P due to spatial restriction and channel restriction of the battery management system BMS receiving a signal of the second type temperature measurement element N through each measurement channel. However, according to various embodiments, the numbers of the first type temperature measurement elements P and second type temperature measurement elements N may be designed to be the same.

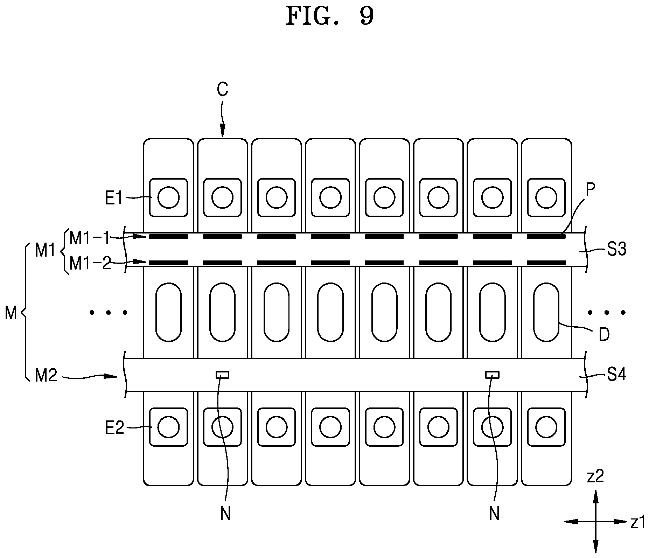

According to various embodiments, the first type temperature measurement element P and second type temperature measurement element N may have a same structure or different structures, and the first type temperature measurement element P or second type temperature measurement element N may be patterned or mounted in a form of a chip on the common base substrate S or individual base substrates S3 and S4 of FIG. 9. According to an embodiment, the first type temperature measurement element P or second type temperature measurement element N may be patterned by using the print screen or patterned by the conductive line CL including the bent portion.

Referring to FIGS. 1 and 2, according to an embodiment, the measurement circuit unit M including the first type temperature measurement element P and second type temperature measurement element N may extend across the electrode surface U of the battery cell C in the first direction Z1. According to various embodiments, the measurement circuit unit M may extend across the wide side surface SS1, the narrow side surface SS2, or the bottom surface B, in addition to the electrode surface U of the battery cell C, and may be arranged to surround at least two of the electrode surface U, wide side surface SS1, narrow side surface SS2, or bottom surface B of the battery cell C.

FIG. 9 is a view for describing a battery pack according to a modified embodiment of FIG. 3. Referring to FIG. 9, the first measurement circuit unit M1 including the first type temperature measurement element P and the second measurement circuit unit M2 including the second type temperature measurement element N may be formed on different individual base substrates S3 and S4, and for example, may be arranged on opposite sides of the battery cells C based on the vent holes D of the battery cells C.

In an embodiment shown in FIG. 9, the first measurement circuit unit M1 may include the pair of first measurement circuit units M1 (the (1-1)th measurement circuit unit M1-1 and (1-2)th measurement circuit unit M1-2) arranged on both sides of the base substrate S3, but according to various embodiments, the first measurement circuit unit M1 may include a single first measurement circuit unit M1 arranged at a center location of the base substrate S3. In this case as well, the first measurement circuit unit M1 and second measurement circuit unit M2 may be respectively arranged on opposite sides of the battery cells C based on the vent holes D of the battery cells C.

In the embodiment shown in FIG. 9, the first measurement circuit units M1 and second measurement circuit units M2 may be formed together on the electrode surfaces U of the battery cells C, but the first measurement circuit units M1 and second measurement circuit units M2 may be arranged on different surfaces from among the electrode surfaces U, wide side surfaces SS1, narrow side surfaces SS2, and bottom surfaces B of the battery cells C, and at least some of the first measurement circuit units M1 and second measurement circuit units M2 may be arranged on different surfaces while surrounding other neighboring surfaces.

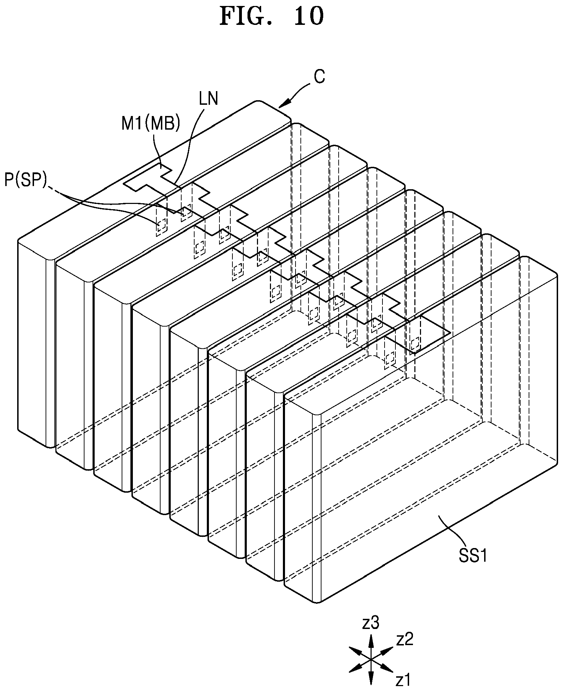

FIG. 10 is a view for describing a battery pack according to a modified embodiment of FIG. 1. Referring to FIG. 10, the battery pack may include the first measurement circuit unit M1 including the first type temperature measurement element P provided between the wide side surfaces SS1 of the neighboring battery cells C, which face each other, in the first direction Z1 in which the battery cells C are arranged. The first measurement circuit unit M1 may be formed by separating a measurement portion SP where the first type temperature measurement element P (or the pair of first type temperature measurement elements P) is arranged from a body portion MB of the first measurement circuit unit M1 through a cut line LN, and then arranging the measurement portion SP separated from the body portion MB of the first measurement circuit unit M1 between the wide side surfaces SS1 of the neighboring battery cells C.

The battery pack of FIG. 10 may include the battery cell C having a flexible pouch shape, and in this case, the first measurement circuit unit M1 may be stably arranged between the wide side surfaces SS1 of the battery cells C, which occupy relatively large areas. According to various embodiments, like the first measurement circuit unit M1, the second measurement circuit unit M2 may include the measurement portion SP separated from the body portion MB through the cut line LN, and may be formed by providing the measurement portion SP between the neighboring battery cells C arranged in the first direction Z1.

Referring to FIGS. 1 and 2, according to an embodiment, the measurement circuit unit M including the first type temperature measurement element P and second type temperature measurement element N may extend across the electrode surface U of the battery cell C in the first direction Z1. According to various embodiments, the measurement circuit unit M may extend across the wide side surface SS1, the narrow side surface SS2, or the bottom surface B, in addition to the electrode surface U of the battery cell C, and may be arranged to surround at least two of the electrode surface U, wide side surface SS1, narrow side surface SS2, or bottom surface B of the battery cell C.

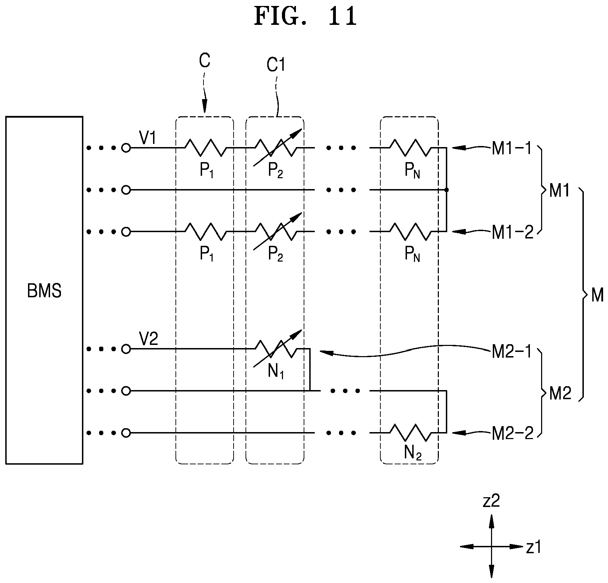

FIG. 11 is a view illustrating a connection state of the first measurement circuit unit M1 and the second measurement circuit unit M2. Referring to FIG. 11, the battery pack according to an embodiment may further include the battery management system BMS connected to both ends of the first measurement circuit unit M1 and second measurement circuit unit M2, and determining an abnormal temperature or overheating of the battery cell C, based on outputs of the first measurement circuit unit M1 and second measurement circuit unit M2. The first measurement circuit unit M1 may include the pair of first measurement circuit units M1 (sub-units or -circuits such as the (1-1)th measurement circuit unit M1-1 and (1-2)th measurement circuit unit M1-2) connected to each other in parallel with respect to the battery management system BMS, and similarly, the second measurement circuit unit M2 may include the pair of second measurement circuit units M2 (the (2-1)th measurement circuit unit M2-1 and (2-2)th measurement circuit unit M2-2) connected to each other in parallel with respect to the battery management system BMS. Here, each of the pair of first measurement circuit units M1 may include the plurality of first type temperature measurement elements P (first type temperature measurement elements P₁ through P_{N}) connected to each other in series in the first direction Z1 in which the battery cells C are arranged, and the pair of second measurement circuit units M2 may respectively include single second type temperature measurement elements N (second type temperature measurement elements N₁ and N₂). According to an embodiment, an output of the first measurement circuit unit M1 may be used to calculate a first measurement value V1 including a resistance change increased according to overheating, through the first type temperature measurement element P₂ allocated to an overheated battery cell C1 from among the first type temperature measurement elements P connected in series. On the other hand, an output of the second measurement circuit unit M2 may be used to calculate a second measurement value V2 including a resistance change decreased according to overheating, through the second type temperature measurement element N₁ corresponding to the overheated battery cell C1 according to measurement locations of the second type temperature measurement elements N included in the second measurement circuit units M2, or calculate the second measurement value V2 that does not include the resistance change according to overheating, through the second type temperature measurement element N₂ free from the overheated battery cell C1.

According to an embodiment, overheating of the battery cell C is determined from a difference value V1-V2 between the first measurement value V1 and second measurement value V2 of the first measurement circuit unit M1 and second measurement circuit unit M2, and in this case, by determining whether the battery cell C is overheated by using an absolute value of the difference value V1-V2 between the first measurement value V1 and second measurement value V2 of the first measurement circuit unit M1 and second measurement circuit unit M2, the battery cell C may be determined to be overheated:
i) when the first measurement value V1 > the second measurement value V2, i.e., when the difference value V1-V2 between the first measurement value V1 and second measurement value V2 is greater than a pre-set threshold value, and
ii) when the second measurement value V2 > the first measurement value V1, i.e., when a difference value V2-V1 between the second measurement value V2 and first measurement value V1 is greater than the pre-set threshold value.

Regarding i), i.e., when the first measurement value V1 > the second measurement value V2, i.e., when the difference value V1-V2 between the first measurement value V1 and second measurement value V2 is greater than the pre-set threshold value:
the second type temperature measurement element N may be allocated to the overheated battery cell C1 or the battery cell C1 to which the second type temperature measurement element N is allocated is overheated. Here, the first type temperature measurement element P and second type temperature measurement element N may both detect overheating of the battery cell C, and due to increment of resistance of the first type temperature measurement element P and decrement of resistance of the second type temperature measurement element N caused by the overheating of the battery cell C, the first measurement value V1 of the first measurement circuit unit M1 including the first type temperature measurement element P and the second measurement value V2 of the second measurement circuit unit M2 including the second type temperature measurement element N may satisfy a relationship of the first measurement value V1 > the second measurement value V2. Also, when the difference value V1-V2 between the first measurement value V1 and second measurement value V2 is equal to or greater than the pre-set threshold value, it may be determined that the battery cell C is overheated.

According to an embodiment, the first measurement value V1 detects the overheated battery cell C1 and the battery cell C that is not overheated together, whereas the second measurement value V2 mainly detects the overheated battery cell C1, and thus the decrement of resistance of the second type temperature measurement element N reflected to the second measurement value V2 is more noticeable than the increment of resistance of the first type temperature measurement element P reflected to the first measurement value V1. Accordingly, the difference value V1-V2 between the first measurement value V1 and second measurement value V2 is increased, and the battery cell C is determined to be overheated when the difference value V1-V2 is equal to or greater than the pre-set threshold value.

According to an embodiment, because the first measurement value V1 is indicated as combined resistance of the first type temperature measurement elements P of the first measurement circuit unit M1, which are connected in series, the first measurement value V1 is determined as a first conversion measurement value. The second measurement value V2 compared with the first measurement value V1 is converted into a second conversion measurement value considering resistance of the second type temperature measurement element N together with the number of first type temperature measurement elements P (or the number of battery cells C). Then, a difference value between the first conversion measurement value and second conversion measurement value may be compared with the threshold value.

The first conversion measurement value and second conversion measurement value to be compared with the threshold value may be values obtained according to the number of all battery cells C, considering the number of all battery cells C. At this time, the first conversion measurement value includes resistance values of both the overheated battery cell C1 (resistance increased due to overheating) and the battery cell C that is not overheated (no increase in resistance due to overheating), but for example, the second conversion measurement value may correspond to a value obtained by multiplying the resistance value of the overheated battery cell C1 (resistance decreased due to overheating) by the number of battery cells C. Accordingly, the decrement of the second conversion measurement value is more noticeable than the increment of the first conversion measurement value, and thus the difference value between the first conversion measurement value and second conversion measurement value may be increased due to overheating of the battery cell C. As such, according to an embodiment, an overheating signal of the battery cell C may be amplified by using the first measurement value V1 and second measurement value V2 or the first conversion measurement value and second conversion measurement value considering the number of all battery cells C rather than outputs of the first type temperature measurement element P and second type temperature measurement element N, and accordingly, overheating of the battery cell C may be detected without omission.

Regarding ii), i.e., when the first measurement value V1 < the second measurement value V2, i.e., when a difference value V2-V1 between the second measurement value V2 and first measurement value V1 is greater than the pre-set threshold value:
the second type temperature measurement element N may be outside a measurement location of the overheated battery cell C1 or a battery cell other than the battery cell C to which the second type temperature measurement element N is allocated is overheated. Here, the first measurement value V1 of the first type temperature measurement element P, which detected the increment of resistance of the overheated battery cell C1, and the second measurement value V2 which did not detect the decrement of resistance of the overheated battery cell C1 may satisfy a relationship of the first measurement value V1 < the second measurement value V2. Also, when the difference value V2-V1 between the first measurement value V1 and second measurement value V2 is equal to or greater than the pre-set threshold value, it may be determined that the battery cell C is overheated.

According to an embodiment, even when the first measurement value V1 increases due to the overheated battery cell C1, the second measurement value V2 may not detect overheating of the battery cell C and thus may have relatively large resistance that is not decreased. Thus, the relationship of the first measurement value V1 < the second measurement value V2 may be satisfied. As described above, according to an embodiment, the first conversion measurement value and second conversion measurement value obtained by considering the number of all battery cells C included in the battery pack may be used considering a difference between the numbers of the first type temperature measurement element P and second type temperature measurement element N. The first measurement circuit unit M1 of the first measurement circuit unit M1 including the same number of first type temperature measurement elements P as the all battery cells C may be used as the first conversion measurement value, and for example, the second conversion measurement value may be obtained by multiplying the second measurement value V2 of the second measurement circuit unit M2 including the single second type temperature measurement element N by the number of battery cells C. Here, the first conversion measurement value includes resistance values of both the overheated battery cell C1 (resistance increased due to overheating) and the battery cell C that is not overheated (no increase in resistance due to overheating), but for example, the second conversion measurement value may be represented by a value obtained by multiplying a resistance value of the battery cell C that is not overheated (no decrease in resistance due to overheating) by the number of battery cells C. Accordingly, the second conversion measurement value without decrease due to overheating of the battery cell C may be relatively noticeable compared to the first conversion measurement value to which the increment of the overheated battery cell C1 is reflected.

According to an embodiment, while determining whether the battery cell C is overheated, determining whether the first measurement value is equal to or greater than a trigger point corresponding to the inflection point CP of the first type temperature measurement element P may be performed before or after determining whether the battery cell C is overheated based on the difference value V1-V2 between the first measurement value V1 and second measurement value V2 or the difference value between the first conversion measurement value and second conversion measurement value, and supplement the determination based on the difference value V1-V2. Also, an error of determining that the battery cell C is overheated even when the battery cell C is not overheated may be prevented ii) when the first measurement value V1 < the second measurement value V2, i.e., when a difference value V2-V1 between the second measurement value V2 and first measurement value V1 is greater than the pre-set threshold value.

According to an embodiment, calculating temperature information based on the first measurement value V1 and second measurement value V2 or the first conversion measurement value and second conversion measurement value may be further performed. Overheating may be supplementarily determined by using the temperature information. For example, determining overheating by using the temperature information may be performed before or after determining overheating based on the difference value V1-V2 between the first measurement value V1 and second measurement value V2 or the difference value between the first conversion measurement value and second conversion measurement value, and supplement the determination based on the difference value V1-V2. Also, an error of determining that the battery cell C is overheated even when the battery cell C is not overheated may be prevented ii) when the first measurement value V1 < the second measurement value V2, i.e., when a difference value V2-V1 between the second measurement value V2 and first measurement value V1 is greater than the pre-set threshold value.

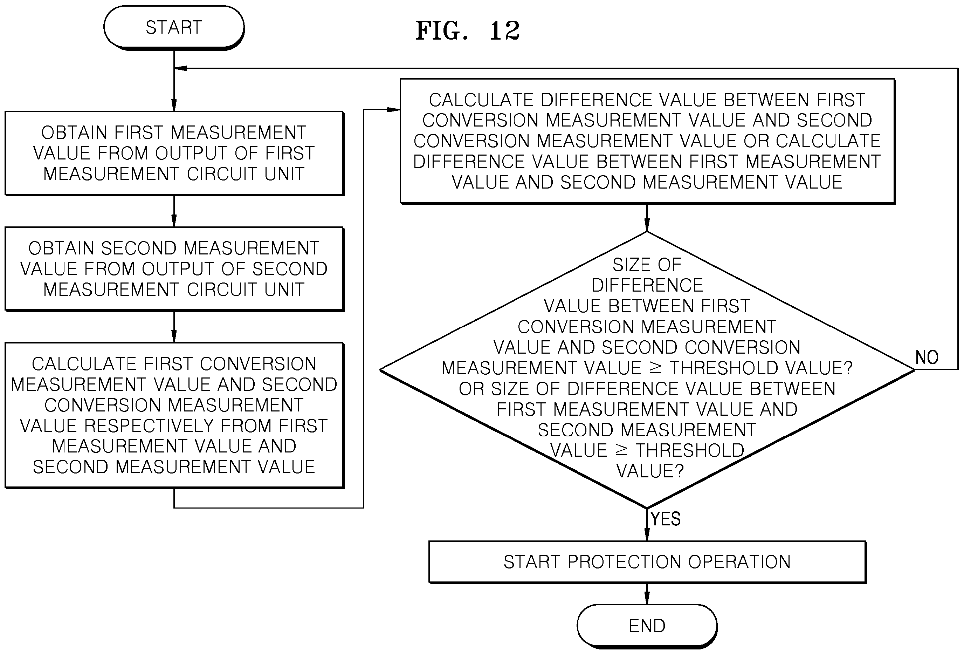

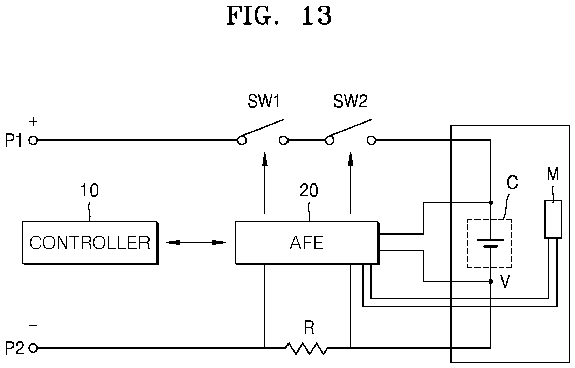

FIG. 12 is a flowchart of a control method for the battery pack, according to an embodiment. FIG. 13 is a view illustrating a schematic configuration of the battery management system BMS, according to an embodiment.

Hereinafter, the control method for the battery pack, according to an embodiment, will be described with reference to FIG. 12.

The control method for the battery pack, according to an embodiment, the battery pack including the battery cells C and the first measurement circuit unit M1 and second measurement circuit unit M2 for measuring the temperature information of the battery cells C and respectively including the first type temperature measurement element P and second type temperature measurement element N having different characteristics of a resistance change according to a temperature change, may determine whether the battery cell C is overheated by using the difference value V1-V2 between the first measurement value V1 based on the output of the first measurement circuit unit M1 and the second measurement value V2 based on the output of the second measurement circuit unit M2.

According to an embodiment, an abnormal temperature or overheating of the battery cell C may be precisely detected by using the first measurement circuit unit M1 and second measurement circuit unit M2 including the first type temperature measurement element P and second type temperature measurement element N having different resistance characteristics.

According to an embodiment, in the first type temperature measurement element P, a profile of the resistance change according to the temperature change may display a nonlinear rapid change above the inflection point CP, and in the second type temperature measurement element N, a profile of the resistance change according to the temperature change may display a linear gradual change. According to an embodiment, it is determined whether the first measurement value V1 is equal to or greater than the trigger point corresponding to the inflection point CP of the first type temperature measurement element P, and when the first measurement value V1 is equal to or greater than the trigger point and the second measurement value V2 is equal to or greater than the threshold value, the battery cell C may be determined to be overheated.

According to an embodiment, the difference value V1-V2 calculated from the first measurement value V1 from the first measurement circuit unit M1 including the first type temperature measurement element P and the second measurement value V2 from the second measurement circuit unit M2 is compared with the threshold value, and an abnormal temperature or overheating of the battery cell C may be determined based on a result of the comparing. Hereinafter, determination on overheating of the battery cell C according to comparison of the difference value V1-V2 between the first measurement value V1 and second measurement value V2 with the threshold value will be described in detail.

The control method for the battery pack, according to an embodiment, may be performed under control by the battery management system BMS or a controller 10 of FIG. 13 configured to control overall operations of the battery management system BMS. A schematic configuration of the battery management system BMS will be described below with reference to FIG. 13.

According to an embodiment, the first measurement value V1 may be obtained from the output of the first measurement circuit unit M1, and may correspond to resistance of the first measurement circuit unit M1 or resistance of the first type temperature measurement element P included in the first measurement circuit unit M1, or correspond to a voltage drop of the first measurement circuit unit M1. Similarly, the second measurement value V2 may be obtained from the output of the second measurement circuit unit M2, and may correspond to resistance of the second measurement circuit unit M2 or resistance of the second type temperature measurement element N included in the second measurement circuit unit M2, or correspond to a voltage drop of the second measurement circuit unit M2.

The controller 10 of FIG. 13 may calculate the first measurement value V1 from the output of the first measurement circuit unit M1, and similarly, calculate the second measurement value V2 from the output of the second measurement circuit unit M2. Also, the controller 10 of FIG. 13 may calculate the first conversion measurement value from the first measurement value V1 and similarly, calculate the second conversion measurement value from the second measurement value V2.

According to a configuration of the measurement circuit unit M, according to an embodiment, the controller 10 of FIG. 13 may calculate the first measurement value V1 and the second measurement value V2, and the first conversion measurement value and second conversion measurement value via different methods. In the configuration of measurement circuit unit M shown in FIG. 6, the controller 10 of FIG. 13 may determine eg calculate, as the first measurement value V1, the combined resistance obtained by combining resistances of the plurality of first type temperature measurement elements P connected to each other in series between both ends of the first measurement circuit unit M1, and determine eg calculate, as the second measurement value V2, resistance of the second type temperature measurement element N connected between both ends of the second measurement circuit unit M2. Here, the controller 10 of FIG. 13 may perform a following calculation process by using the first measurement value V1 as the first conversion measurement value, and calculate the second conversion measurement value through separate conversion for the second measurement value V2. In detail, the first conversion measurement value corresponds to the combined resistance obtained by combining the resistances of the plurality of first type temperature measurement elements P connected to each other in series between both ends of the first measurement circuit unit M1, and thus the second conversion measurement value may also be determined eg calculated as combined resistance obtained by combining resistances of the same number of second type temperature measurement elements N as the first type temperature measurement elements P. In detail, the controller 10 of FIG. 13 may calculate the second conversion measurement value by multiplying the resistance (a representative value described below) of the single second type temperature measurement element N connected between both ends of the second measurement circuit unit M2 by the number of first type temperature measurement elements P.

According to an embodiment, there may be two or more second measurement circuit units M2, and different second measurement values V2 may be obtained based on outputs of the different second type temperature measurement elements N included in the different second measurement circuit units M2. One second measurement value V2 selected from the different second measurement values V2, for example, the second measurement value V2 having a largest value, may be used as the representative value, and the second conversion measurement value may be calculated by multiplying the representative value by the number of first type temperature measurement elements P. According to various embodiments, the controller 10 of FIG. 13 may use an average value of the different second measurement values V2 as the representative value and calculate the second conversion measurement value by multiplying the representative value by the number of first type temperature measurement elements P.

According to an embodiment, the number of first type temperature measurement elements P connected to each other between both ends of the first measurement circuit unit M1 may be the same as the number of all battery cells C arranged in the first direction Z1, and for example, the first type temperature measurement elements P may be allocated respectively to the battery cells C arranged in the first direction Z1. In such a configuration, the controller 10 of FIG. 13 may obtain the second conversion measurement value by multiplying the representative value obtained from the resistances of the second type temperature measurement elements N by the number of battery cells C instead of the number of first type temperature measurement elements P. According to an embodiment, the first measurement circuit unit M1 may include the pair of first measurement circuit units M1 each including the same number of first type temperature measurement elements P as the battery cells C so as to provide redundancy in preparation for disconnection. Here, the number of first type temperature measurement elements P may denote the number of battery cells C or the number of first type temperature measurement elements P included in each first measurement circuit unit M1, the number of first type temperature measurement elements P included in the pair of first measurement circuit units M1 may denote a multiple of the number of battery cells C, and the number of first type temperature measurement elements P included in the pair of first measurement circuit units M1 may not be considered while calculating the second conversion measurement value.

In the configuration of measurement circuit unit M shown in FIG. 7, the controller 10 of FIG. 13 may calculate, as the first measurement value V1, total combined resistance obtained by combining combined resistance, in which resistances of the plurality of first type temperature measurement elements P connected to each other in series between both ends of the first measurement circuit unit M1 (the (1-1)th measurement circuit unit M1-1) are combined, with combined resistance, in which resistances of the plurality of first type temperature measurement elements P connected to each other in series between both ends of another first measurement circuit unit M1 (the (1-2)th measurement circuit unit M1-2) are combined. Also, the controller 10 of FIG. 13 may calculate, as the second measurement value V2, the resistance of the second type temperature measurement element N connected between the both ends of the second measurement circuit unit M2. Here, the controller 10 of FIG. 13 may perform the following calculation process by using the first measurement value V1 as the first conversion measurement value, and calculate the second conversion measurement value through separate conversion for the second measurement value V2. In detail, the first conversion measurement value corresponds to the total combined resistance obtained by combining the combined resistance, in which the resistances of the plurality of first type temperature measurement elements P connected to each other in series between both ends of the first measurement circuit unit M1 are combined, with the combined resistance, in which the resistances of the plurality of first type temperature measurement elements P connected to each other in series between both ends of the other first measurement circuit unit M1 are combined, and thus the second conversion measurement value may also be calculated as combined resistance obtained by combining resistances of the same number of second type temperature measurement elements N as the first type temperature measurement elements P. In detail, the controller 10 of FIG. 13 may calculate the second conversion measurement value by multiplying the resistance (the representative value described below) of the single second type temperature measurement element N connected between both ends of the second measurement circuit unit M2 by the number of first type temperature measurement elements P.

Regarding the number of first type temperature measurement elements P for calculating the second conversion measurement value, the first measurement circuit unit M1 may include the pair of different first measurement circuit unit M1 so as to provide redundancy in preparation for disconnection. The first measurement circuit unit M1 may include the (1-1)th measurement circuit unit M1-1 including the plurality of first type temperature measurement elements P allocated to the front battery cells C in the first direction Z1, and the (1-2)th measurement circuit unit M1-2 including the plurality of first type temperature measurement elements P allocated to the rear battery cells C in the first direction Z1. The number of first type temperature measurement elements P may correspond to a number obtained by adding the number of first type temperature measurement elements P included in the (1-1)th measurement circuit unit M1-1 and the number of first type temperature measurement elements P included in the (1-2)th measurement circuit unit M1-2. According to an embodiment, the same number of first type temperature measurement elements P as the battery cells C arranged in the first direction Z1 may be provided, and the first type temperature measurement elements P may be respectively allocated to the battery cells C arranged in the first direction Z1. For example, the battery cells C arranged in the first direction Z1 may be halved, and the first type temperature measurement elements P of the (1-1)th measurement circuit unit M1-1 may be allocated to the front half of the battery cells C and the first type temperature measurement elements P of the (1-2)th measurement circuit unit M1-2 may be allocated to the rear half of the battery cells C. Here, the total number of first type temperature measurement elements P may be the same as the number of battery cells C, and may correspond to the number obtained by adding the numbers of first type temperature measurement elements P included in the (1-1)th measurement circuit unit M1-1 and (1-2)th measurement circuit unit M1-2.

Regarding the representative value of the second type temperature measurement elements N for calculating the second conversion measurement value, there may be two or more second measurement circuit unit M2, and one second measurement value V2 selected from among the different second measurement values V2, for example, the second measurement value V2 having a largest value, may be used as the representative value, and the second conversion measurement value may be calculated by multiplying the representative value by the number of first type temperature measurement elements P. According to various embodiments, the controller 10 of FIG. 13 may use an average value of the different second measurement values V2 as the representative value and calculate the second conversion measurement value.

As will be described below, according to an embodiment, an abnormal temperature or overheating of the battery cell C may be sensed based on the difference value between the first conversion measurement value and second conversion measurement value. According to various embodiments, the number of first type temperature measurement elements P and the number of second type temperature measurement elements N may be the same, and the first type temperature measurement elements P connected between both ends of the first measurement circuit unit M1 and the second type temperature measurement elements N connected between both ends of the second measurement circuit unit M2 may be connected in various manners, such as in series and in parallel. Thus, according to various embodiments, the difference value between the first conversion measurement value and second conversion measurement value may be comprehensively represented as the difference value V1-V2 between the first measurement value V1 and second measurement value V2. In the present specification, the difference value between the first conversion measurement value and second conversion measurement value includes a meaning wherein the numbers of first type temperature measurement element P and second type temperature measurement element N are matched to be the same, and more broadly, may be represented by the difference value V1-V2 between the first measurement value V1 and second measurement value V2. Hereinafter, to prevent confusion before and after conversion, the difference value between the first conversion measurement value and second conversion measurement value is described instead of the difference value V1-V2 between the first measurement value V1 and second measurement value V2, but more broadly, the difference value between the first conversion measurement value and second conversion measurement value may be comprehensively represented by the difference value V1-V2 between the first measurement value V1 and second measurement value V2. For reference, according to an embodiment, the difference value between the first conversion measurement value and second conversion measurement value or the difference value V1-V2 between the first measurement value V1 and second measurement value V2 may be considered only quantitatively and positive(+)/negative(-) thereof may not be referred to. In this regard, the difference value may be represented by an absolute value of the difference value between the first conversion measurement value and second conversion measurement value, and the controller 10 of FIG. 13 may define the difference value as data having only size without a sign or convert the difference value into an absolute value through a function, and compare the difference value with a threshold value in size as described below.

Referring to FIG. 11, according to an embodiment, overheating of the battery cell C is determined from the difference value V1-V2 between the first measurement value V1 and second measurement value V2 of the first measurement circuit unit M1 and second measurement circuit unit M2, and in this case, by determining whether the battery cell C is overheated by using the absolute value of the difference value V1-V2 between the first measurement value V1 and second measurement value V2 of the first measurement circuit unit M1 and second measurement circuit unit M2, the battery cell C may be determined to be overheated:
i) when the first measurement value V1 > the second measurement value V2, i.e., when the difference value V1-V2 between the first measurement value V1 and second measurement value V2 is greater than the pre-set threshold value, and
ii) when the second measurement value V2 > the first measurement value V1, i.e., when a difference value V2-V1 between the second measurement value V2 and first measurement value V1 is greater than the pre-set threshold value.

Regarding i), i.e., When the first measurement value V1 > the second measurement value V2, i.e., when the difference value V1-V2 between the first measurement value V1 and second measurement value V2 is greater than the pre-set threshold value,:
the second type temperature measurement element N may be allocated to the overheated battery cell C1 or the battery cell C1 to which the second type temperature measurement element N is allocated is overheated. Here, the first type temperature measurement element P and second type temperature measurement element N may both detect overheating of the battery cell C, and due to the increment of resistance of the first type temperature measurement element P and the decrement of resistance of the second type temperature measurement element N caused by the overheating of the battery cell C, the first measurement value V1 of the first measurement circuit unit M1 including the first type temperature measurement element P and the second measurement value V2 of the second measurement circuit unit M2 including the second type temperature measurement element N may satisfy the relationship of the first measurement value V1 > the second measurement value V2. Also, when the difference value V1-V2 between the first measurement value V1 and second measurement value V2 is equal to or greater than the pre-set threshold value, it may be determined that the battery cell C is overheated.

According to an embodiment, the first measurement value V1 detects the overheated battery cell C1 and the battery cell C that is not overheated together, whereas the second measurement value V2 mainly detects the overheated battery cell C1, and thus the decrement of resistance of the second type temperature measurement element N reflected to the second measurement value V2 is more noticeable than the increment of resistance of the first type temperature measurement element P reflected to the first measurement value V1. Accordingly, the difference value V1-V2 between the first measurement value V1 and second measurement value V2 is increased, and the battery cell C is determined to be overheated when the difference value V1-V2 is equal to or greater than the pre-set threshold value.

According to an embodiment, because the first measurement value V1 is indicated as the combined resistance of the first type temperature measurement elements P of the first measurement circuit unit M1, which are connected in series, the first measurement value V1 is determined as the first conversion measurement value. The second measurement value V2 compared with the first measurement value V1 is converted into the second conversion measurement value considering the resistance of the second type temperature measurement element N together with the number of first type temperature measurement elements P (or the number of battery cells C). Then, the difference value between the first conversion measurement value and second conversion measurement value may be compared with the threshold value.

The first conversion measurement value and second conversion measurement value to be compared with the threshold value may be values obtained according to the number of all battery cells C, considering the number of all battery cells C. At this time, the first conversion measurement value includes resistance values of both the overheated battery cell C1 (resistance increased due to overheating) and the battery cell C that is not overheated (no increase in resistance due to overheating), but for example, the second conversion measurement value may correspond to a value obtained by multiplying the resistance value of the overheated battery cell C1 (resistance decreased due to overheating) by the number of battery cells C. Accordingly, the decrement of the second conversion measurement value is more noticeable than the increment of the first conversion measurement value, and thus the difference value between the first conversion measurement value and second conversion measurement value may be increased due to overheating of the battery cell C. As such, according to an embodiment, an overheating signal of the battery cell C may be amplified by using the first measurement value V1 and second measurement value V2 or the first conversion measurement value and second conversion measurement value considering the number of all battery cells C rather than outputs of the first type temperature measurement element P and second type temperature measurement element N, and accordingly, overheating of the battery cell C may be detected without omission.

Regarding ii), i.e., when the first measurement value V1 < the second measurement value V2, i.e., when the difference value V2-V1 between the second measurement value V2 and first measurement value V1 is greater than the pre-set threshold value,:
the second type temperature measurement element N may be outside a measurement location of the overheated battery cell C1 or the battery cell C other than the battery cell C to which the second type temperature measurement element N is allocated is overheated. Here, the first measurement value V1 of the first type temperature measurement element P, which detected the increment of resistance of the overheated battery cell C1, and the second measurement value V2 which did not detect the decrement of resistance of the overheated battery cell C1 may satisfy the relationship of the first measurement value V1 < the second measurement value V2. Also, when the difference value V2-V1 between the first measurement value V1 and second measurement value V2 is equal to or greater than the pre-set threshold value, it may be determined that the battery cell C is overheated.

According to an embodiment, even when the first measurement value V1 increases due to the overheated battery cell C1, the second measurement value V2 may not detect overheating of the battery cell C and thus may have relatively large resistance that is not decreased. Thus, the relationship of the first measurement value V1 < the second measurement value V2 may be satisfied. As described above, according to an embodiment, the first conversion measurement value and second conversion measurement value obtained by considering the number of all battery cells C included in the battery pack may be used considering the difference between the numbers of the first type temperature measurement element P and second type temperature measurement element N. The first measurement circuit unit M1 of the first measurement circuit unit M1 including the same number of first type temperature measurement elements P as the all battery cells C may be used as the first conversion measurement value, and for example, the second conversion measurement value may be obtained by multiplying the second measurement value V2 of the second measurement circuit unit M2 including the single second type temperature measurement element N by the number of battery cells C. Here, the first conversion measurement value includes resistance values of both the overheated battery cell C1 (resistance increased due to overheating) and the battery cell C that is not overheated (no increase in resistance due to overheating), but for example, the second conversion measurement value may be represented by a value obtained by multiplying a resistance value of the battery cell C that is not overheated (no decrease in resistance due to overheating) by the number of battery cells C. Accordingly, the second conversion measurement value without decrease due to overheating of the battery cell C may be relatively noticeable compared to the first conversion measurement value to which the increment of the overheated battery cell C1 is reflected.

According to an embodiment, while determining whether the battery cell C is overheated, determining whether the first measurement value is equal to or greater than the trigger point corresponding to the inflection point CP of the first type temperature measurement element P may be performed before or after determining whether the battery cell C is overheated based on the difference value V1-V2 between the first measurement value V1 and second measurement value V2 or the difference value between the first conversion measurement value and second conversion measurement value, and supplement the determination based on the difference value V1-V2. Also, an error of determining that the battery cell C is overheated even when the battery cell C is not overheated may be prevented for example, ii) when the first measurement value V1 < the second measurement value V2, i.e., when a difference value V2-V1 between the second measurement value V2 and first measurement value V1 is greater than the pre-set threshold value.

According to an embodiment, calculating the temperature information based on the first measurement value V1 and second measurement value V2 or the first conversion measurement value and second conversion measurement value may be further performed. Overheating may be supplementarily determined by using the temperature information. For example, determining overheating by using the temperature information may be performed before or after determining overheating based on the difference value V1-V2 between the first measurement value V1 and second measurement value V2 or the difference value between the first conversion measurement value and second conversion measurement value, and supplement the determination based on the difference value V1-V2. Also, an error of determining that the battery cell C is overheated even when the battery cell C is not overheated may be prevented ii) when the first measurement value V1 < the second measurement value V2, i.e., when a difference value V2-V1 between the second measurement value V2 and first measurement value V1 is greater than the pre-set threshold value.

According to an embodiment, the threshold value may be set as below. The threshold value is a value to be compared with the difference value V1-V2 between the first measurement value V1 and second measurement value V2 or with the difference value between the first conversion measurement value and second conversion measurement value, and for example, may be set to a difference value between first temperature data calculated from resistance of one group of first type temperature measurement elements P indicated by the first conversion measurement value and second temperature data calculated from resistance of one group of second type temperature measurement elements N indicated by the second conversion measurement value.

The one group of first type temperature measurement elements P may denote the number of first type temperature measurement elements P corresponding to a calculation basis of the first conversion measurement value, and according to an embodiment, may denote the plurality of first type temperature measurement elements P included in the first measurement circuit unit M1. The one group of second type temperature measurement elements N may denote the number of second type temperature measurement elements N corresponding to a calculation basis of the second conversion measurement value, and according to an embodiment, may denote the same number of second type temperature measurement elements N as the plurality of first type temperature measurement elements P included in the first measurement circuit unit M1.

The first temperature data is temperature data calculated from the resistance of the one group of first type temperature measurement elements P. The first temperature data is a quantitative parameter collectively defining temperatures of the plurality of battery cells C configuring the battery pack rather than a temperature of individual battery cell C calculated from individual first type temperature measurement element P, and may denote temperature data calculated collectively from resistances of the one group of first type temperature measurement elements P rather than a qualitative temperature.

Similarly, the second temperature data is temperature data calculated from the resistance of the one group of second type temperature measurement elements N. The second temperature data is a quantitative parameter collectively defining temperatures of the plurality of battery cells C configuring the battery pack rather than a temperature of individual battery cell C calculated from individual second type temperature measurement element N, and may denote temperature data calculated collectively from resistances of the one group of second type temperature measurement elements N rather than a qualitative temperature.

For example, according to an embodiment, the first temperature data and second temperature data do not denote qualitative temperature information of individual battery cell C, but collectively define temperature information of the plurality of battery cells C, and may be parameters that include the temperature information of the plurality of battery cells C but are on different levels from the temperature information. For example, the first temperature data and second temperature data may be understood as temperature information output from behaviors of the first type temperature measurement element P and second type temperature measurement element N of FIGS. 4 and 5 by using, as an input, collective resistances of the groups of first type temperature measurement element P and second type temperature measurement element N. Here, because the first temperature data and second temperature data use, as the input, the collective resistances of the groups of first type temperature measurement element P and second type temperature measurement element N instead of resistance of individual first type temperature measurement element P and second type temperature measurement element N, the first temperature data and second temperature data output by using, as the input, the collective resistances of the groups of first type temperature measurement element P and second type temperature measurement element N may be different from a temperature of individual battery cell C.

According to an embodiment, the first temperature data and second temperature data are based on the behaviors of the first type temperature measurement element P and second type temperature measurement element N as shown in FIGS. 4 and 5, output resistances of the first type temperature measurement element P and second type temperature measurement element N by using a reference temperature for determining overheating as an input, and may be defined by the output resistances of the first type temperature measurement element P and second type temperature measurement element N and the numbers of groups of first type temperature measurement element P and second type temperature measurement element N that are basis of the first conversion measurement value and second conversion measurement value, respectively. The difference value between the first temperature data and second temperature data calculated as such may be pre-set as the threshold value.

According to an embodiment, the first temperature data and second temperature data may be in units of resistance, or may be in units of temperature output from resistance based on the behaviors of the first type temperature measurement element P and second type temperature measurement element N shown in FIGS. 4 and 5. For example, when the threshold value is in units of temperature, according to an embodiment, the first conversion measurement value and second conversion measurement value that are to be compared with the threshold value may also be in units of temperature. For example, the first conversion measurement value and second conversion measurement value may respectively correspond to values obtained by outputting temperatures of the first type temperature measurement element P and second type temperature measurement element N shown in FIGS. 4 and 5, by using resistance of the group of first type temperature measurement elements P and resistance of the group of second type temperature measurement element N as inputs.

According to an embodiment, an abnormal temperature or overheating of the battery cell C may be determined based on the threshold value by detecting a case where a temperature difference between a first temperature based on the resistance of the first type temperature measurement element P and a second temperature based on the resistance of the second type temperature measurement element N is between 10 °C to 15 °C (for example, a difference between the first temperature and the second temperature is a temperature set between 10 °C to 15 °C). In other words, the first temperature data and second temperature data are calculated from the resistances of the first type temperature measurement element P and second type temperature measurement element N at a time when the temperature difference between the first temperature based on the resistance of the first type temperature measurement element P and the second temperature based on the resistance of the second type temperature measurement element N is a temperature between 10 °C and 15 °C, and a difference value between the first temperature data and second temperature data may be set as the threshold value.

Referring to FIGS. 4 and 5, a difference value between the first conversion measurement value based on the first type temperature measurement element P, in which the resistance change according to the temperature change displays a positive characteristic, and the second conversion measurement value based on the second type temperature measurement element N, in which the resistance change according to the temperature change displays a negative characteristic, increases according to an increase in temperature, and thus when the difference value increases by a certain value or greater, the battery cell C may be determined to have an abnormal temperature or to be overheated. Here, regarding the threshold value for determining an abnormal temperature or overheating of the battery cell C, the first temperature data and second temperature data may be calculated from the resistances of the group of first type temperature measurement element P and group of second type temperature measurement element N at a time when the temperature difference between the first temperature based on the resistance of the first type temperature measurement element P and the second temperature based on the resistance of the second type temperature measurement element N is a temperature between 10 °C and 15 °C, and the difference value between the first temperature data and second temperature data may be set as the threshold value.

Another aspect of setting the threshold value is as follows. Referring to FIGS. 4 and 5, a resistance characteristic of the first type temperature measurement element P rapidly increases according to the temperature change at a high temperature section, and thus an error may occur in temperature measurement. Such an error in temperature measurement may gradually increase according to the increase in temperature. To compensate for such a resistance characteristic of the first type temperature measurement element P, the second type temperature measurement element N is applied in parallel together with the first type temperature measurement element P, the first temperature data and second temperature data may be calculated from the resistances of the group of first type temperature measurement element P and group of second type temperature measurement element N at a time when the temperature difference between the first temperature based on the resistance of the first type temperature measurement element P and the second temperature based on the resistance of the second type temperature measurement element N is a temperature between 10 °C and 15 °C, and the difference value between the first temperature data and second temperature data may be set as the threshold value.

According to an embodiment, it is determined that a threshold condition is satisfied when the temperature difference between the first temperature and second temperature corresponds to a temperature pre-set between 10 °C and 15 °C, for example, it is determined that the threshold condition is satisfied when the temperature difference between the first temperature and second temperature is 10 °C from among 10 °C to 15 °C. In an embodiment, a case where the temperature difference between the first temperature and second temperature is 10 °C may be set as the threshold condition or threshold value for early detection of an abnormal temperature or overheating of the battery cell C. However, according to various embodiments, a case where the temperature difference between the first temperature and second temperature is, for example, 15 °C may be set as the threshold condition or threshold value considering an increase in temperature in a situation such as high-speed charging of the battery cell C.

According to an embodiment, the measurement circuit unit M may be electrically connected to the battery management system BMS. For example, the terminal Me of FIGS. 6 and 7 provided at one end of the measurement circuit unit M may be connected to a connector (not shown) of the battery management system BMS. Referring to FIG. 13, the battery management system BMS may include the controller 10 configured to control overall operations of the battery management system BMS, and an analog front end (AFE) 20 connected to the measurement circuit unit M to receive an output of the measurement circuit unit M, converting an output regarding temperature information received from the measurement circuit unit M into a quantized digital value and transmitting the same to the controller 10, and outputting an on/off control signal for a charging switch SW2 and a discharging switch SW1, according to a control signal of the controller 10. The battery management system BMS may receive information about a temperature and voltage through a voltage measurement terminal V and measurement circuit unit M arranged at a location adjacent to the battery cell C. A current sensor R is provided on charging and discharging paths of the battery cell C to measure charging and discharging current amounts of the battery cell C.

According to an embodiment, as described above, the controller 10 may calculate the difference value V1-V2 between the first measurement value V1 and second measurement value V2 based on outputs of the first measurement circuit unit M1 and second measurement circuit unit M2 and compare the calculated difference value V1-V2 with the pre-set threshold value, thereby detecting an abnormal temperature or overheating of the battery cell C based on a result of the comparing. Upon detecting that the battery cell C is overheated, the controller 10 may start a protection operation for stopping charging and discharging operations of the battery cell C by outputting an off signal for the charging switch SW2 and/or discharging switch SW1, and accordingly, prevent an accident, such as an explosion or ignition, leading from the overheating of the battery cell C.

According to embodiments, provided are a battery pack and a control method for the battery pack, wherein erroneous detection of overheating may be prevented and overheating may be detected without omission by mixing a first type temperature measurement element and a second type temperature measurement element, which have different resistance characteristics according to a temperature change.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims.

## Claims

1. A battery pack comprising:
battery cells; and
a measurement circuit unit configured to measure temperature information of the battery cells and including a first measurement circuit unit and a second measurement circuit unit, which respectively include a first type temperature measurement element and a second type temperature measurement element that have different characteristics of a resistance change according to a temperature change, wherein the first measurement circuit unit and the second measurement circuit unit are on a common base substrate or on different individual base substrates.

2. The battery pack of claim 1, wherein the first type temperature measurement element has a positive characteristic as a characteristic of the resistance change according to the temperature change, and
the second type temperature measurement element has a negative characteristic as a characteristic of the resistance change according to the temperature change.

3. The battery pack of claim 1 or 2, wherein the battery cells are arranged in a first direction,
the first measurement circuit unit includes a pair of the first measurement circuit units arranged on both sides of the measurement circuit unit in a second direction crossing the first direction, and
the second measurement circuit unit includes a pair of the second measurement circuit units arranged on both sides of the measurement circuit unit in the second direction.

4. The battery pack of claim 3, further comprising a battery management system configured to determine whether the battery cells are overheated based on outputs of the pairs of first measurement circuit units and second measurement circuit units.

5. The battery pack of claim 4, wherein the pair of first measurement circuit units are connected in parallel to each other with respect to the battery management system, and
the pair of second measurement circuit units are connected in parallel to each other with respect to the battery management system.

6. The battery pack of any one of claims 3 to 5, wherein the pair of first measurement circuit units are arranged at edge locations of the both sides of the measurement circuit unit in the second direction,
a ground wire is arranged at a center location of the measurement circuit unit between the pair of first measurement circuit units, and
the pair of second measurement circuit units are arranged respectively between the ground wire and different first measurement circuit units configuring the pair of first measurement circuit units.

7. The battery pack of any one of claims 3 to 6, wherein:
the pair of first measurement circuit units have a symmetric structure, wherein the axis of symmetry is at a center location between the first measurement circuit units and extends in the second direction;
the first type temperature measurement element is arranged between both ends of each first measurement circuit unit configuring the pair of first measurement circuit units to be balanced back and forth in the first direction, and one first measurement circuit unit from among the pair of first measurement circuit units provides redundancy for another remaining first measurement circuit unit; and/or
the first type temperature measurement element is arranged to be biased towards a forward location in the first direction between both ends of one first measurement circuit unit configuring the pair of first measurement circuit units, and arranged to be biased toward a backward location in the first direction between both ends of another remaining first measurement circuit unit configuring the pair of first measurement circuit units.

8. The battery pack of any preceding claim, wherein:
the first type temperature measurement element includes a plurality of first type temperature measurement elements connected to each other in series between both ends of the first measurement circuit unit, and the second type temperature measurement element includes a single second type temperature measurement element connected between both ends of the second measurement circuit unit;
the battery cells are arranged in the first direction, and the first type temperature measurement element is arranged in one column in a first direction at an edge location of the measurement circuit unit in a second direction crossing the first direction;
a plurality of the first type temperature measurement elements are arranged to be allocated for each of the battery cells in a first direction in which the battery cells are arranged, and a plurality of the second type temperature measurement elements are arranged in a number same as or less than the plurality of first type temperature measurement elements;
the first type temperature measurement element or the second type temperature measurement element is patterned or mounted in a form of a chip on the common base substrate or individual base substrates; and/or
the first type temperature measurement element or the second type temperature measurement element is patterned with a print screen or patterned with a conductive line including a bent portion.

9. The battery pack of any preceding claim, wherein each of the battery cells includes an electrode surface where an electrode is formed, a bottom surface opposite to the electrode surface, and a wide side surface occupying a relatively large area and a narrow side surface occupying a relatively small area, which connect the electrode surface and the bottom surface to each other, preferably wherein:
at least one of the first measurement circuit unit and the second measurement circuit unit is arranged at least on a electrode surface of the battery cells;
at least one of the first measurement circuit unit and the second measurement circuit unit is arranged at least on the wide side surface of the battery cells;
at least one of the first measurement circuit unit and the second measurement circuit unit is arranged at least on the narrow side surface of the battery cell; and/or
at least one of the first measurement circuit unit and the second measurement circuit unit is arranged at least on the bottom surface of the battery cells.

10. The battery pack of any preceding claim, wherein:
the battery cells include an angular battery cell including a case having a hexahedral shape, a circular battery cell including a case having a cylindrical shape, or a pouch battery cell including a case having a pouch shape, the case forming an exterior of the battery cells; and/or
the common base substrate or individual base substrates include a flexible insulating film or a rigid insulating substrate.

11. A control method for a battery pack including: battery cells; and a measurement circuit unit configured to measure temperature information of the battery cells and including a first measurement circuit unit and a second measurement circuit unit, which respectively include a first type temperature measurement element and a second type temperature measurement element that have different characteristics of a resistance change according to a temperature change, the control method comprising determining whether the battery cells are overheated by using a difference value between a first measurement value based on an output of the first measurement circuit unit and a second measurement value based on an output of the second measurement circuit unit.

12. The control method of claim 11, wherein the first type temperature measurement element has a positive characteristic as a characteristic of the resistance change according to the temperature change, and
the second type temperature measurement element has a negative characteristic as a characteristic of the resistance change according to the temperature change.

13. The control method of claim 11 or 12, wherein:
the first type temperature measurement element displays a nonlinear rapid change above an inflection point of a profile of the resistance change according to the temperature change, and the second type temperature measurement element displays a linear gradual change in the profile of the resistance change according to the temperature change;
the method further comprising determining whether the first measurement value is equal to or greater than a trigger point corresponding to an inflection point of the first type temperature measurement element, and when the first measurement value is equal to or greater than the trigger point while the difference value between the first measurement value and the second measurement value is equal to or greater than a threshold value, determining that the battery cells are overheated; and/or
the first measurement value and the second measurement value change according to the temperature change while following resistance changes of the first type temperature measurement element and the second type temperature measurement element, respectively, and a size of a difference value between the first measurement value and the second measurement value increases according to an increase in a temperature.

14. The control method of any one of claims 11 to 13, wherein the determining of whether the battery cells are overheated comprises determining that the battery cells are overheated when the difference value between the first measurement value and the second measurement value is equal to or greater than a threshold value, as a result of comparing the difference value with the threshold value,
preferably wherein the threshold value is a value pre-set to a difference value between first temperature data based on resistance of the first type temperature measurement element and second temperature data based on resistance of the second type temperature measurement element.

15. The control method of any one of claims 11 to 14, wherein:
the difference value between the first measurement value and the second measurement value is calculated by using a first conversion measurement value and a second conversion measurement value, which are preferably obtained by converting a number of first type temperature measurement elements included in the first measurement circuit unit and a number of second type temperature measurement elements included in the second measurement circuit unit to be equal;
the first measurement circuit unit includes a plurality of the first type temperature measurement elements arranged to be allocated for each of the battery cells according to a first direction in which the battery cells are arranged, and the second measurement circuit unit includes different second measurement circuit units including single second type temperature measurement elements, respectively, preferably wherein the plurality of first type temperature measurement elements are connected to each other in series between both ends of the first measurement circuit unit, and the single second type temperature measurement elements are connected between both ends of the different second measurement circuit units; and/or
the first conversion measurement value and the second conversion measurement value are obtained by converting the first measurement value based on the output of the first measurement circuit unit into the first conversion measurement value, and converting, into the second conversion measurement value, a value obtained by multiplying a number of battery cells by a representative value from among different second measurement values based on outputs of the different second measurement circuit units.
